# EUROPEAN PATENT SPECIFICATION

(11) **EP 4 001 902 B1**
(45) Date of publication and mention of the grant of the patent: **14.10.2026**
(21) Application number: 20209199.7
(22) Date of filing: 23.11.2020
(51) Int. Cl.: G03F 7/00, G06N 3/08, G06N 3/045, G06T 11/00, G06V 10/82, G06V 20/64, G06N 3/0464, G06N 3/0475, G06N 3/09, G06T 7/00, G06N 5/01, G01N 21/956, G01N 21/95, G01N 21/88

(54) **METHOD AND SYSTEM FOR SIMULATING AN OPTICAL IMAGE OF A PHOTONIC AND/OR ELECTRONIC DEVICE**
VERFAHREN UND SYSTEM ZUR SIMULATION EINES OPTISCHEN BILDES EINES FOTONISCHEN UND/ODER ELEKTRONISCHEN ARTIKELS
MÉTHODE ET SYSTÈME DE SIMULATION D'UNE IMAGE OPTIQUE D'UN ARTICLE PHOTONIQUE ET/OU ÉLECTRONIQUE

(43) Date of publication of application: 25.05.2022
(73) Proprietor: Fraunhofer-Gesellschaft zur Förderung der angewandten Forschung e.V., 80686 München (DE)
(72) Inventor: WAGNER, Patrick, 13189 Berlin (DE); ABDEEN, Oliver, 10559 Berlin (DE); Lapuschkin, Sebastian, 10589 Berlin (DE); Baier, Moritz, 10629 Berlin (DE); Wojciech, Samek, 12249 Berlin (DE)
(74) Representative: Maikowski & Ninnemann Patentanwälte Partnerschaft mbB

(56) References cited:
- EP-A1- 3 951 496
- WO-A1-2020/156777
- US-A1- 2015 067 618
- US-A1- 2017 140 524
- US-A1- 2017 148 226
- US-A1- 2018 293 721
- US-A1- 2022 128 899

## Description

The invention relates to a method for simulating an optical image of a photonic and/or electronic device according to claim 1, a method for training a neural network according to claim 8, a system for simulating an optical image of a photonic and/or electronic device according to claim 9 and a computer program product according to claim 11.

Automated optical inspection of microelectronics, semiconductors or photonic components is a known approach for quality assurance and the detection of defects. Several inspection methods are known such as template matching (TM) or die-to-die inspection (DDI). Template matching performs comparisons between samples and a manually chosen reference images ("golden" photos) for detecting deviations. Die-to-die inspection compares neighbouring chipset units on a produced wafer for pair-wise irregularities and thus may be used efficiently only in mass-production settings. Further, US 2016/029093 A1 discloses a system for generating a rendered image based on information for a design printed on the wafer and for comparing the rendered image to an optical image of the wafer generated by the optical inspection subsystem. However, the implementation of this system is complex. EP 3 951 496 A1 discloses a method for selecting patterns for training machine learning models. WO 2022/086825 A1 discloses a method for calculating a pattern to be manufactured on a substrate. EP 3 951 496 A1 and WO 2022/086825 A1 represent prior art pursuant to Art. 54(3) EPC. US 2017/148226 A1 and WO 2020/156777 A1 disclose systems and methods using neural networks to generate simulated images for patterning processes.

The object of the invention is to permit an efficient implementation of defect detection and/or device preview.

According to the invention, a method for simulating an optical image of a photonic and/or electronic device, in particular fabricated on a semiconductor wafer, comprising the steps as set out in independent claim 1.

The neural network according to the invention thus is trained in order to simulate the (physical) result of a production process based on the CAD data (in particular in the form of CAD templates). The neural network is able to produce the visual expression of a reference device or a reference wafer (i.e. a gold standard device or wafer), i.e. assuming that the device or the wafer has a low density of production errors. That is, an optical image of the device portion is simulated that is supposed to resemble a photographic image captured of a real device (by an imaging device such as a camera) in a state after carrying out the predefined number of production steps. The neural network may be used to simulate perfect devices regardless of the design used for production or training based on design data (in particular relating to local portions of the entire design) from the CAD data as a ground truth. The simulation of the optical image (the simulated image) can be compared with an image of the actually produced device or wafer for defect detection as will be explained further below.

The simulated optical image may correspond to a state of the device after carrying out only some of the production steps (such as a coating, etching, plating, growing) necessary for completing the production of the device, i.e. the simulated optical image may show an intermediate state of the device. However, the "predefined number" of production steps may also be the total number of production steps, i.e. the simulated optical image shows a simulation of an optical image of the final device.

According to an embodiment of the invention, the CAD data represents a structure of at least one photolithography mask to be used during the production steps. In particular, the CAD data represent structures of a plurality of photolithography masks to be used in sequence. For example, the CAD data is organized in a pre-determined number k of layers. At least one of the layers may represent the structure of one photolithography mask. In particular, there is a one-to-one mapping between the layers and the photolithography masks.

A plurality of the devices may be produced simultaneously on the same (e.g. semiconductor) wafer. The entire production process consists of a predetermined total number (e.g. about 25) of production steps in which material (in particular semiconductor layers) is structured (e.g. etched, deposited or grown) in a spatially defined manner. The spatial definition is encoded in the CAD data and is physically transferred to the wafer by means of photolithography using the photolithography masks. Therefore, there may be a one-to-one correspondence between the CAD data layers and the production steps. This in particular may allow the neural network to output a simulated optical image of the device in a state after each individual production step and not only of the final device, i.e. the result of the complete production process. Thus, predictors for intermediate production steps may be obtained and the neural network may be re-used in different production flows in a modular manner.

The neural network of the method according to the invention in particular may be trained to generate as a result a simulation of an optical image of only a portion of the device based on the CAD data (which equally represent the design of only a portion of the device), wherein the portion of the device shown in the simulated optical image corresponds to the design of the portion represented by the CAD data. Within this embodiment, the neural network thus may be trained to create a mapping from the CAD data (e.g. representing a sequence of lithography steps) towards their visual expression on a local scale such that the method may be agnostic to the actual design of the device used for training of the neural network or during production and testing. The neural network may therefore be transferred to future production runs, and may be used as a measure for quality assurance.

As set forth above, the CAD data (the CAD blueprint) may be organized in a number (k) of layers. Each one of the layers may be assigned (e.g. provide input) to one of the production steps to be carried out in sequence. The CAD data may be stored electronically in a such way that discretized (pixel-based) or vector-graphics representations can be generated on demand. In particular, the CAD data are a pixel based or a vector graphics representation of the device. For providing CAD data representing a series of production steps, i.e. the layers {1, ..., *k*} (wherein, for example, k does not exceed 23) encoding a specific target state of the device in the production process, the device design (e.g. a vector graphics representation of the device) may be discretized into a (e.g. binary) bit mask having e.g. k layers (wherein each layer may correspond to a production step and a lithography mask, respectively). Further, depending on parameters h, w and k a portion of the bit mask is selected that is supplied as input data to the neural network. Parameters h and w may represent the size of the bit mask portion (e.g. h and w correspond to a number of pixels of the selected bit map portion, while k represents the layer, the last layer or the number of the layers to be selected). For example, the selected bit mask portion may comprise a combination of some or all layers 1-k. The h and w section of the tensor e.g. contains binary values assigned to the pixels of the extracted bit mask portion. The bit map portion supplied to the neural network may be extracted from the original bitmap as a (h x w x k) tensor. Further, in each depth-slice [:; :; i] of the tensor, binary values may encode whether the ith production step will by applied by the current process or not.

The h and w parameters, i.e. the size of the extracted bit map portion, may be chosen freely (e.g. at sufficient magnitude) such that the provided design data (the bit mask portion) can be aligned appropriately to data of a real image of a portion of a real device (see below). In particular, a real image of a portion of a real device (e.g. after k production steps) is captured and the parameters h and w are chosen in such a way that the size of the bit mask portion supplied to the neural network corresponds to the size of the real image of the portion of the real device. It is noted that instead of using a bit mask derived from the CAD data as input data it is also conceivable that another kind of input data is derived from the CAD data or that the CAD data (or a portion thereof) is used directly as the input data to the neural network, i.e. the CAD data may be the input data received by the neural network. The CAD data may be generated e.g. by any device configured to generate graphics.

According to an embodiment of the invention, generating the simulation of an optical image by the neural network comprises generating color values forming the simulated optical image. The color values may be based on a given color scheme. For example, the color values are RGB values which may be assigned to each one of the pixels of the generated simulated image. As already mentioned above, the neural network may receive a bit mask as input data, which in turn represents the design of a portion (a local segment) of the device after k production steps. The neural network may then be trained to predict a (*h* x *w* x c) shaped output as simulation corresponding to an optical image of the real device in a state after the production steps encoded in the CAD data (the CAD blueprint instructions). In the above expression, c is the number of data (e.g. colour) channels of the optical data representation, e.g. c = 3 for images in RGB space. Parameters h and w as mentioned above may represent the size (e.g. corresponding pixel numbers) of the input data such that the output data (the simulated image) may have a corresponding or identical size.

The architecture of the neural network may consist of two functional parts: First, a contracting path, i.e. a series of layers extracting information from the input CAD data, and e.g. the input tensors described above, by spatially compressing feature maps with each learned or applied layer (or transformation). The second part of the neural network may be described as an expansive path, which iteratively merges and combines the information of each layer output from the contracting path. However, the invention is not restricted to a particular neural network. In principle, any neural network architecture may be used for producing the simulated optical image of the device.

According to the invention, generating the simulation of an optical image by the neural network comprises assigning each one of the color values to one of a plurality of color categories. The devices, in particular if the devices are photonic devices, may be produced within tightly defined parameter ranges, e.g. following a strictly controlled production process. The resulting devices or wafers and images of those thus may show a high regularity in their visual expression, most notably in the (reduced) set of occurring colors. This high color space regularity may be exploited in a "binning" procedure, wherein each one of the color values is assigned to a particular color category. For example, the (h; w; 3) shaped RGB-images may be transferred into (h; w; t)-shaped representations of the same image, by discretizing each pixel's color information into one of t possible values. This process is also known as color quantization. Possible quantization approaches include for example t-means (or other) clustering approaches for finding notable and densely occupied points in RGB color space. Each of those found cluster centroids or descriptors may represent one identified density in color space, e.g., a frequently and well-defined color value or distribution occurring in the (photographic) images of the device.

In the resulting (h; w; t)-shaped and quantized representation of the wafer image, each pixel at location (h; w) is represented as a t-dimensional binary vector (instead of a 3-dimensional vector of continuous color values) encoding its visual representation in color space. Continuous color vectors may be quantized by "binning" a 3-dimensional color vector from the original device (simulated and/or real) image into one (or multiple, e.g. via soft-mapping approaches) of the t categories (bins), which may represent the closest corresponding color density in a color space (e.g. in the RGB-space). A bin may represent a particular material type.

In order to make sure that all relevant color values are duly represented for quantization, specific color values may be added to the empirically identified t quantization points. This might be of use for, e.g., capturing and considering color values characteristic to certain defect types during the binning (the assignment of the color values to the color categories), in case the data used for training the neural network does not show any such defects at all.

In this embodiment, the training of the neural network may be affected by the change in image representation compared to the embodiment that is based on a neural network that produces color values as output. While the neural network in the latter embodiment may be optimized to solve a regression task (the generation of the correct and expected color values), the neural network of this embodiment may be trained to predict via a (pixel-wise) classification, or segmentation task. Therefore, a wider range of different loss functions may be used for optimization. This task may be easier for the neural network to solve, as the margin for errors may be larger since the objective is simplified to hit the right bin (e.g. of material type), compared to the prediction of the correct color value. It is noted that with this embodiment simulated device or wafer images can still be generated. During data processing, the color values of wafer images have been quantized, i.e. a color palette has been generated. After a bin assignment (e.g. a material type prediction) using this embodiment, a simulated image can be generated by assigning the corresponding palette color to each pixel's bin (e.g. material type).

The method according to the invention comprises capturing a real optical image of at least a portion of a real device produced by carrying out the predefined number of production steps, wherein the portion of the real device corresponds to the portion of the design of the device represented by the CAD data; and using the real optical image and the simulated optical image in order to detect defects of the device (e.g. determining whether or not the device comprises a defect based on the real optical image and the simulated optical image). For example, a trained defect detection model is used, wherein an input to the model comprises or consists of the real optical image and the simulated optical image.

Further, the step of determining whether or not the device comprises a defect may comprise comparing the real optical image with the simulated optical image in order to detect defects of the device. For example, a heuristic or trained model may be used to generate information that allow to determine whether the device comprises a defect. In particular, the model or another entity may determine whether a defect is present based on the comparison between the real optical image and the simulated optical image. For example, the real optical image of the real device is a microscopic image.

While the CAD data exists in purely digital form from the beginning to the end and enables full control over the data, the image data after real device recorded after the kth production step (and potentially after each ith production step with i < k) depend on the (physio-chemical) production process used to produce the device. The produced wafer maybe be physically moved along a production line until it may be transferred to an imaging device (e.g. a microscope). Using the imaging device, an image of at least a portion of the device or the wafer will be generated. For example, the image may be generated by producing an assembly of local (e.g. high-resolution) images (e.g. at a predefined optical magnification) and image stitching. The output of this imaging process may be optical RGB or HSV data and may also incorporate further or alternative information such as specific optical wavelengths, etc.

Moreover, the CAD data may contain information representing at least one alignment landmark, and wherein the real optical image is aligned to the simulated optical image using the at least one alignment landmark. The image of the device or the wafer may in general not be aligned with the CAD data (i.e. the design blueprint of the device), and might be affected by differences in translation, rotation and scaling. The landmark may have any suited shape, wherein, in principle, any suited number of landmarks might be used. For example, the CAD data may represent landmarks in the form of squares. For example, twelve key points at the corners of the three large squares in the CAD data and in the image are identified and used. Via the computation of a homography matrix between the landmark of the CAD data and the corresponding landmark in the real optical image, e.g. between the above-mentioned sets of key points, the image-to-CAD data alignment can be performed by aligning the image and the CAD data. Further, the conditions for capturing the real optical images, e.g. the camera angle (which may be perpendicular to the device), the illumination and/or the magnification, may be chosen to be identical for each image and e.g. to be identical or at least as close as possible to the conditions used when capturing the target image data as part of the training of the neural network.

The device may be a photonic device, e.g. an integrated photonic circuit. The photonic device may be fabricated in indium phosphide technology, i.e. using an indium phosphide substrate (wafer). However, the device could also be an electronic device.

In another aspect, the invention also relates to a method for training a neural network, in particular for use in the method described above, comprising the steps as set out in claim 8.

Step e) may comprise determining a difference between the real optical image and the simulated optical image. For example, if the difference is above a pre-determined threshold the neural network may be adjusted and steps d) and e) repeated.

The neural network, which in particular is used as the neural network of the method for simulating an optical image according to the invention, may have a known neural network design. For example, the neural network has a U-Net architecture as described in the article Olaf Ronneberger et al., "U-net: Convolutional networks for biomedical image segmentation", international conference on medical image computing and computer-assisted intervention, pages 234-241, Springer, 2015. As already mentioned above, the network may consist of a contracting path, i.e. a series of layers extracting information from input tensors by spatially compressing the feature maps, and an expansive path, which iteratively merges and combines the information of each layer output from the contracting path. The flexible nature of U-Net neural networks may allow for simultaneous training on various target scales (e.g. optical magnifications), which may enable the neural network to perform multi-scale image generation.

The neural network, in particular if it has a U-Net architecture, may be trained for the task of (color) image prediction from the CAD data, wherein the contracting path of the neural network may serve as an encoder of the CAD data and the following expansive path as a decoder for optical image information. Mini-batches (x; y) may be provided to the neural network, wherein x is a portion (a local segment) of the CAD data (the "blueprint information"), and y the target ground truth image for decoding. By employing appropriate data augmentation strategies and training the neural network on a local scale (i.e. by providing input segments of the design of a scale below that of complete device or wafer), the neural network may learn an approximative mapping from the (logical) CAD data to the visual expression of the device in an intermediate or final state.

Further, a low rate of errors appearing during production, which make the (manual) detection of errors a difficult process, may provide only little importance to the learning and encoding of such defects during the training process. More particularly, the neural network may be trained as an image generator which in general does not produce visualizations of production defects, but outputs simulations of perfect devices or wafers instead. For example, only a small subset of locally sourced CAD data, i.e. CAD data representing the design of only a small portion of the device or wafer, and corresponding image fragments from a first produced (i.e. real) device or wafer of a series of devices or wafers to be produced may be sufficient for training the neural network, wherein a training time of less than one minute may be sufficient. This may allow for an immediate application of the neural network as an error detector from the first produced device or wafer on, in particular without specific tuning per production run, and may render the above-described method for simulation and error detection a work efficient, simple and flexible one. It is noted that the neural network can optionally be continuously trained during the simulation in order to improve the accuracy of its mapping over multiple production runs.

The invention also relates to a system for simulating an optical image of a photonic and/or electronic device, in particular for carrying out the method for simulating according to the invention, as set out in independent claim 9.

The CAD device and the neural network device may be programmed devices, e.g. separate or common devices. Further, features of the above-described embodiments of the method for simulation according to the invention may of course be used in combination with the system according to the invention. The system comprises an imaging device (e.g. including a microscope device as already described above) configured to generate a real optical image of at least a portion of a real device produced by carrying out the predefined number of production steps, wherein the portion of the real device corresponds to the portion of the design of the device represented by the CAD data; and a defect detection device configured to detect defects of the photonic and/or electronic device using the real optical image and the simulated optical image. For example, the defect detection device is configured to compare the real optical image with the simulated optical image in order to detect defects of the photonic and/or electronic device. The defect detection device may comprise a trained model (e.g. a trained neural network) and may be realized by a programmed device. For example, the defect detection device and the neural network device for generating simulated images may be realized by the same device.

There may be for example two approaches to the detection of defects. For one, heuristics may be used in order to identify anomalously built structures on the produced devices or wafers. Given that the production process follows the rules of physics and chemistry, certain (known and common) defects will express themselves in an expected way. That is, they will deviate from the norm (i.e. the simulated wafer) in foreseeable ways, e.g. in colour or material type. For a photonic device (wafer) foundry, the following cases may cover over 99.5 percent of all relevant occurring defects:
- Failed lift-off process. This defect can be detected by searching for unpredicted surfaces with a certain colour difference to a predicted background (of the simulated device image). The colour difference serves as classification mechanism.
- Point defects. These can be detected by searching for surfaces with a predictable grey scale difference to the prediction (i.e. the simulated device image).
- Metal degradation. This defect can be detected by searching for predicted surfaces in certain layers that deviate from the predicted colour.
- Dust particles. These may be detected like point defects above but will have an at least an order of magnitude larger surface area.
- Residual resist. These may be detected similar to dust particles, but the aspect ratio is going to be far from unity. Resist that is not completely removed after development tends to form dash like structures.

By using detection functions measuring the deviations from expectations, it may be abstained from labelled data for training specific detectors for the above five types of defects. Using the method for simulation according to the invention in the framework of defect detection may provide an efficient unsupervised defect detection. However, it is of course possible to use a trained model or neural network for defect detection.

For example, with the on-going collection of (automatically and manually) labelled data over production time, one can build a rich labelled dataset over known defects. In this case, a dedicated defect detector (e.g. a trained model, in particular is trained neural network) may be provided in addition to the neural network used for the simulation of device images. Such a defect detection model may mimick the behaviour of heuristically designed detection functions, which, however, may be fine tuned using labelled training data, either individually (by adapting the model) or jointly with the model. Using the embodiment described above, wherein each one of color values generated by the neural network is assigned to one of a plurality of color categories, the assigned categories (e.g. in the form of material bins) may directly compared between the simulated device image and the simulation of the defect model. The defect density may thus be a measurable quantity.

As already mentioned above, the neural network and the defect model are based on the simulation of generic production processes of photonic wafers such that the resulting model(s) may be re-used for future production runs and can even be continuously retrained and fine tuned. Further, as the intent of the simulating neural network may be the generation of "gold standard" image data, further defect types or classes may conveniently added and their detectors tuned at a later time, once necessary.

The invention also relates to a computer program product comprising instructions which, when the program is executed by a computer (a programmable device), cause the computer to carry out the steps of the method according to the invention.

The method and the system according to the invention in particular may be employed with in the following scenarios:

### a) Chip preview services

Customers of a chip foundry can obtain predicted optical photographs of their designs directly after submission of their designs, before any fabrication steps are performed. Those may e.g. be used for public relation and dissemination purposes or to allow inexperienced designers to spot problems that are not obvious in the layout view.

### b) Automated visual inspection reports

After fabrication of the devices or wafers, individual reports for customers based on the defect detection may be generated. Fatal defects may be spotted and shipment of the affected chips prevented. On the other hand, if defects occur after shipment e.g. due to improper handling by the customer, there is an easy way to refute liability for the foundry.

### c) In-line detection of faulty devices or wafers

If the method according to the invention is implemented on a per production step basis, failed process steps may be identified directly after they occurred. If a defect is irreversible, the affected wafer process can be halted altogether. This may save costs and also permit considerable savings in terms of energy consumption, as semiconductor processing is energy intensive. Furthermore, more wafers may be started much earlier if they are needed to fulfill contractual obligations of the foundry.

Outside of giving early indicators for failed wafers, the method and the system according to the invention also may allow the detection of faulty processes. It can give an early indication of a processing tool like a dry etcher to operate out of its specifications, if irregularities are detected.

Embodiments of the invention will be described hereinafter with reference to the drawings, which show:
- Figure 1: steps of a method according to an embodiment of the invention;
- Figure 2: steps during a detection of device defects using the result of the method according to the invention; and
- Figure 3: steps of a method for training a neural network according to an embodiment of the invention.

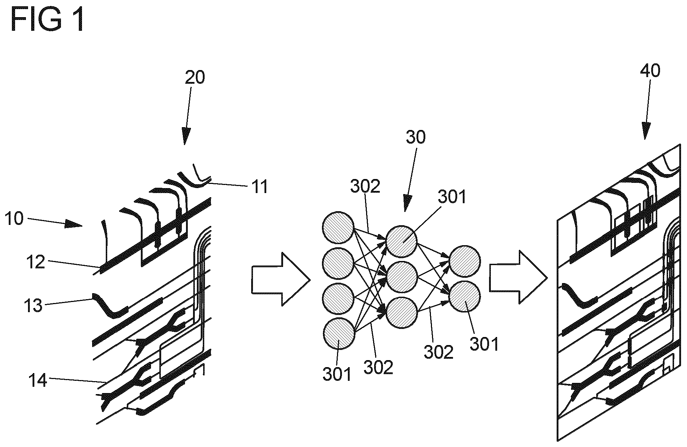

According to the embodiment of the invention illustrated in Figure 1, CAD data 10 is provided by a CAD system. The CAD data 10 represents the design of a portion 20 of a photonic device that would be obtained if a predefined number of production steps would be carried out using the CAD data 10. More particularly, the CAD data 10 comprises four layers 11-14 of data, wherein each one of the layers 11-14 represents the structure of a photolithography mask (not shown). In other words, the CAD data 10 could be used for producing four photolithography masks, wherein each one of the four photolithography mask is used in one production step of a production process for producing the photonic device. During each one of the (four) production steps, the structure of the corresponding photolithography mask is transferred to a wafer, i.e. a substrate, for example an indium phosphide substrate, that may contain one or more semiconductor layers. The CAD data 10 shown in Figure 1 thus comprise information about the design of the portion of the device that would be obtained after the four production steps. Of course, the CAD data 10 may comprise more or less than four layers (corresponding to more or less than four photolithography masks and production steps, respectively).

The CAD data 10 may be used as input data and transferred directly to a simulation neural network 30. In another embodiment, the input data to the neural network is created based (dependent) on the CAD data 10. For example, a bit mask is derived from the CAD data 10 and a portion of the bit mask is used as input data. The CAD data 10 may be in the GDS format, wherein the GDS format may be converted into a vector graphics format (such as the SVG format). The size and/or orientation of the graphic represented by the SVG data may be adapted to the size and orientation of a real image of a real device portion (that is to be compared to the simulated image generated by the neural network as will be explained below). Subsequently, the SVG data graphic is discretized (rasterized) into a bit mask having a number k of channels (wherein the channels correspond to the layers of the CAD data 10). The bit mask is the input data transferred to the neural network 30.

The neural network 30 is trained to generate a simulation of an optical image (a simulated optical image) of the portion 20 of the device represented by the CAD data 10. The simulated optical image 40 is thus an output of the neural network 30 and may comprise colour values associated with pixel coordinates. Image 40 thus simulates a photography of the device portion 20 in a state after the four production steps have been carried out. Of course, a simulated image could be generated for only some of the four production steps. For example, a simulated image could be output by the neural network for each one of the layers 11 to 14 such that a simulated photography of the device portion 20 would be generated for each intermediate state after one production step.

According to another embodiment, the simulated optical image 40 comprises or consists of bin data, wherein the colour values are assigned to a category (bin), e.g. a corresponding material property or a material type, as already set forth above.

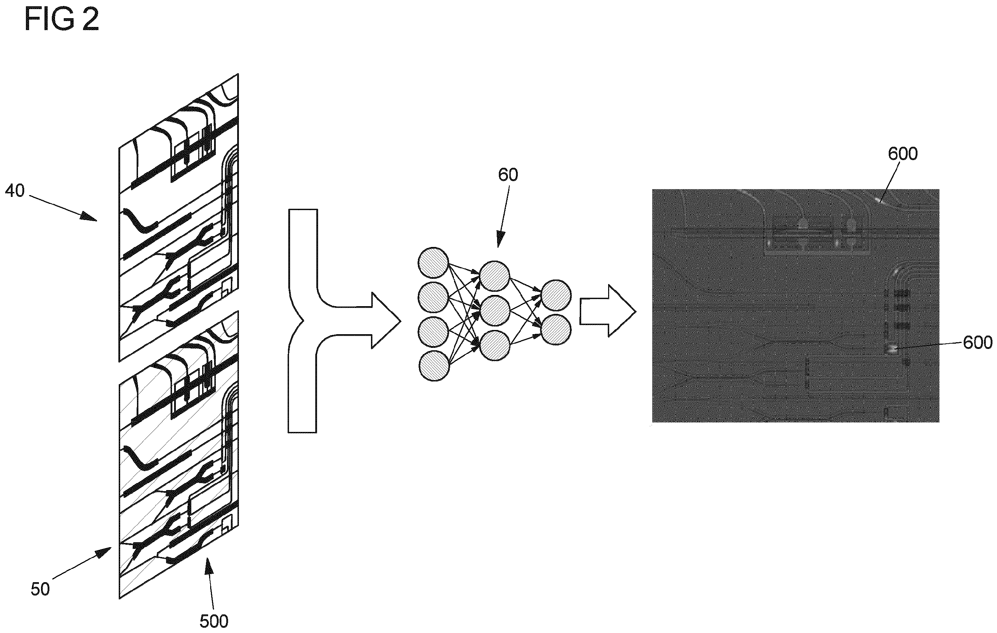

For the detection of defects of a real device produced by carrying out the production steps mentioned above in conjunction with Figure 1, a photographic image 50 of a portion 500 of the device is captured (e.g. using a microscope equipped with a camera) and compared to the simulated image 40 of the device portion 20 as illustrated in Figure 2. The captured portion 500 of the real device corresponds to the portion of the device contained in the simulated image 40 (and thus corresponds to the portion 20 of the device represented by the CAD data 10). For example, differences between the simulated image 40 and the photographic image 50 are determined, e.g. by determining differences between colour values of corresponding image coordinates (pixels). Before comparing the simulated image 40 and the photographic image 50, the images 40 and 50 may be aligned using landmarks contained in the CAD data 10 as described above.

Alternatively, images 40 and 50 may be represented by discretized colour values as already mentioned above. In this case, instead of determining differences between colour values of corresponding image pixels, e.g. differences regarding the colour classification (quantization) may be determined and used for defect detection.

The result of the comparison between images 40 and 50, e.g. the difference, is then received by a trained defect detection model 60, e.g. a defect detection neural network. The defect detection model 60 outputs a defect prognosis. For example, the defect detection model 60 outputs a plurality of numerical values which can be analyzed to determine whether or not the device comprises a defect. It is also possible that the defect detection model 60 carries out that analysis. In Figure 2, the output of the defect detection model 60 is illustrated as an image in which possible defects 600 (e.g. areas of larger structural deviation from the simulated image 40) are recognizable as bright areas

Further, it is also possible that the detection model 60 receives the images 40 and 50 directly (i.e. not the result of a comparison between these images). The (trained) model, which may use specific and/or learned function for determining a difference between images 40 and 50, outputs an information whether the device comprises a defect based on the received images 40 and 50.

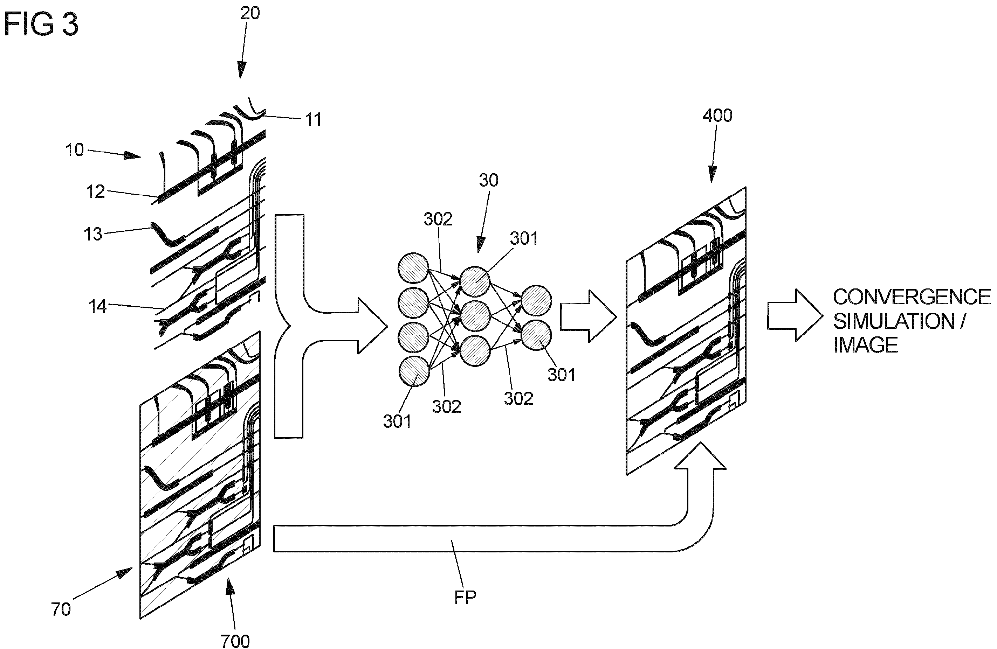

Figure 3 illustrates the training process used for training the simulation neural network 30 of Figure 1. The training is carried out by using the CAD data 10 or other input data derived from the CAD data 10 and a real photographic image 70 of a device portion 700 that corresponds to the device portion 20 represented by the CAD data 10. The real photographic image 70 may be captured during the production of a first wafer of a batch of wafers to be produced. This approach in particular may be used in conjunction with production processes that usually do not create a high number of defects. Of course, the real photographic image 70 may be an image of a device that has been classified as defect free or at least as having a number of defects below a predetermined threshold.

The real photographic image 70 of device portion 700 is used as a target output of the neural network 30 and thus is compared to a simulated image 400 (of a device portion corresponding to portion 700) generated by the neural network 30 receiving the CAD data 10 as input (forward pass FP). An output image 400 of neural network 30 is compared to the real photographic image 70. Depending on this comparison the neural network 30 is adjusted in a generally known manner (in particular by adjusting weights 302 of nodes 301 of the neural network 30) and a new output image 400 is generated. For example, if a result of the comparison does not meet predefined criteria (an error function) - such as a difference between the real photographic image 70 and the output image 400 being below a predetermined threshold - weights 302 are adjusted. In particular, the error function is supplied backwards to the neural network 30. The above steps are repeated using multiple forward and backward passes until the output image 400 converges towards the real photographic image 70.

## Claims

1. A method for simulating an optical image of a photonic and/or electronic device, comprising the steps of:
- providing CAD data (10) representing a design of at least a portion (20) of the photonic and/or electronic device after a predefined number of production steps of a production process for producing the photonic and/or electronic device;
- receiving input data based on the CAD data (10) by a neural network (30), wherein the neural network (30) is trained to generate a simulation of an optical image of the photonic and/or electronic device based on the received input data;
- generating, by the neural network (30), a simulation (40) of an optical image of at least the portion (20) of the photonic and/or electronic device represented by the CAD data (10), wherein generating the simulation (40) of the optical image by the neural network (30) is based on a color quantization process, wherein color information is discretized into one of a plurality of color categories, and wherein an output of the neural network (30) comprises or consists of data related to the color categories;
- capturing a real optical image (50) of at least a portion (500) of a real photonic and/or electronic device produced by carrying out the predefined number of production steps, wherein the portion (500) of the real photonic and/or electronic device corresponds to the portion (20) of the design of the photonic and/or electronic device represented by the CAD data (10); and
- using the real optical image (50) and the simulated optical image (40) in order to detect defects (600) of the photonic and/or electronic device.

2. The method as claimed in claim 1, wherein the CAD data (10) represents a structure of at least one photolithography mask to be used during the production steps.

3. The method as claimed in claim 1 or 2, wherein the CAD data (10) is organized in a pre-determined number k of layers (11-14).

4. The method as claimed in claim 3, wherein at least one of the layers (11-14) represents a structure of one photolithography mask.

5. The method as claimed in any of the preceding claims, wherein the CAD data (10) is a pixel based or a vector graphics representation of at least the portion (20) of the photonic and/or electronic device.

6. The method as claimed in any of claims 3 to 5, wherein the input data is a bit mask obtained by discretizing at least a portion of the CAD data (10).

7. The method as claimed in any of the preceding claims, wherein the CAD data (10) contain information representing at least one alignment landmark, and wherein the real optical image (50) is aligned to the simulated optical image (40) using the at least one alignment landmark.

8. A method for training a neural network, in particular for use in the method as claimed in any of the preceding claims, comprising the steps of:
a) providing CAD data (10) representing the design of at least a portion (20) of the photonic and/or electronic device after a predefined number of production steps of a production process for producing the photonic and/or electronic device;
b) providing a real optical image (70) of at least a portion (700) of a real photonic and/or electronic device produced by carrying out the predefined number of production steps, wherein the portion (700) of the real photonic and/or electronic device corresponds to the portion (20) of the design of the photonic and/or electronic device represented by the CAD data (10);
c) receiving input data based on the CAD data (10) by the neural network (30);
d) generating, by the neural network (30) and based on the received input data, a simulation (400) of an optical image of at least the portion (20) of the photonic and/or electronic device represented by the CAD data (10), wherein generating the simulation (400) of the optical image by the neural network (30) is based on a color quantization process, wherein color information is discretized into one of a plurality of color categories, and wherein an output of the neural network (30) comprises or consists of data related to the color categories; and
e) comparing the real optical image (70) and the simulated optical image (400).

9. A system for simulating an optical image of a photonic and/or electronic device, in particular for carrying out the method as claimed in any of claims 1 to 7, comprising:
- a CAD device configured to provide CAD data (10) representing a design of at least
a portion (20) of the photonic and/or electronic device after a predefined number of production steps of a production process for producing the photonic and/or electronic device; and
- a neural network device comprising a neural network (30) configured to receive input data based on the CAD data (10), wherein the neural network (30) is trained to generate a simulation (40) of at least the portion (20) of an optical image of the photonic and/or electronic device represented by the CAD data (10) based on the received input data, wherein generating the simulation (40) of the optical image by the neural network (30) is based on a color quantization process, wherein color information is discretized into one of a plurality of color categories, and wherein an output of the neural network (30) comprises or consists of data related to the color categories;
- an imaging device configured to generate a real optical image (50) of at least a portion (500) of a real photonic and/or electronic device produced by carrying out the predefined number of production steps, wherein the portion (500) of the real photonic and/or electronic device corresponds to the portion (20) of the design of the photonic and/or electronic device represented by the CAD data (10); and
- a defect detection device configured to detect defects (600) of the photonic and/or electronic device using the real optical image (50) and the simulated optical image (40).

10. The system as claimed in claim 9, wherein the defect detection device is configured to compare the real optical image (50) with the simulated optical image (40) in order to detect defects of the photonic and/or electronic device.

11. Computer program product comprising instructions which, when the program is executed by a computer, cause the computer to carry out the steps of the method as claimed in any of claims 1 to 8.

## Patentansprüche

1. Verfahren zum Simulieren eines optischen Bildes einer photonischen und/oder elektronischen Vorrichtung, mit den folgenden Schritten:
- Bereitstellen von CAD-Daten (10), die eine Konstruktion von mindestens einem Abschnitt (20) der photonischen und/oder elektronischen Vorrichtung repräsentieren, nach einer vordefinierten Anzahl von Fertigungsschritten eines Herstellungsverfahrens zur Herstellung der photonischen und/oder elektronischen Vorrichtung;
- Empfangen von auf den CAD-Daten (10) basierenden Eingangsdaten durch ein neuronales Netz (30), wobei das neuronale Netz (30) trainiert wird, um eine Simulation eines optischen Bildes der photonischen und/oder elektronischen Vorrichtung auf der Basis der empfangenen Eingangsdaten zu erzeugen;
- Erzeugen, durch das neuronale Netz (30), einer Simulation (40) eines optischen Bildes von mindestens dem Abschnitt (20) der durch die CAD-Daten (10) repräsentierten photonischen und/oder elektronischen Vorrichtung, wobei das Erzeugen der Simulation (40) des optischen Bildes durch das neuronale Netz (30) auf einem Farbquantisierungsprozess basiert, wobei die Farbinformation in eine Farbkategorie einer Vielzahl von Farbkategorien diskretisiert wird, und wobei ein Ausgang des neuronalen Netzes (30) Daten umfasst oder aus Daten besteht, die sich auf die Farbkategorien beziehen;
- Erfassen eines realen optischen Bildes (50) von mindestens einem Abschnitt (500) einer realen photonischen und/oder elektronischen Vorrichtung, die durch die Ausführung der vordefinierten Anzahl von Fertigungsschritten hergestellt wurde, wobei der Abschnitt (500) der realen photonischen und/oder elektronischen Vorrichtung dem Abschnitt (20) der Konstruktion der durch die CAD-Daten (10) repräsentierten photonischen und/oder elektronischen Vorrichtung entspricht; und
- Verwenden des realen optischen Bildes (50) und des simulierten optischen Bildes (40), um Fehler (600) der photonischen und/oder elektronischen Vorrichtung zu erkennen.

2. Verfahren nach Anspruch 1, wobei die CAD-Daten (10) eine Struktur mindestens einer während der Fertigungsschritte zu verwendenden Photolithographiemaske repräsentieren.

3. Verfahren nach Anspruch 1 oder 2, wobei die CAD-Daten (10) in einer vorbestimmten Anzahl k von Schichten (11-14) organisiert sind.

4. Verfahren nach Anspruch 3, wobei mindestens eine der Schichten (11-14) eine Struktur einer Photolithographiemaske repräsentiert.

5. Verfahren nach einem der vorhergehenden Ansprüche, wobei die CAD-Daten (10) eine pixelbasierte oder vektorgraphische Darstellung von mindestens dem Abschnitt (20) der photonischen und/oder elektronischen Vorrichtung sind.

6. Verfahren nach einem der Ansprüche 3 bis 5, wobei die Eingangsdaten eine durch Diskretisieren mindestens eines Abschnitts der CAD-Daten (10) erhaltene Bitmaske sind.

7. Verfahren nach einem der vorhergehenden Ansprüche, wobei die CAD-Daten (10) Informationen enthalten, die mindestens eine Orientierungshilfe für die Ausrichtung repräsentieren, und wobei das reale optische Bild (50) unter Verwendung der mindestens einen Orientierungshilfe für die Ausrichtung auf das simulierte optische Bild (40) ausgerichtet wird.

8. Verfahren zum Trainieren eines neuronalen Netzes, insbesondere zur Verwendung bei dem Verfahren nach einem der vorhergehenden Ansprüche, mit den folgenden Schritten:
a) Bereitstellen von CAD-Daten (10), welche die Konstruktion von mindestens einem Abschnitt (20) der photonischen und/oder elektronischen Vorrichtung repräsentieren, nach einer vordefinierten Anzahl von Fertigungsschritten eines Herstellungsverfahrens zur Herstellung der photonischen und/oder elektronischen Vorrichtung;
b) Bereitstellen eines realen optischen Bildes (70) von mindestens einem Abschnitt (700) einer realen photonischen und/oder elektronischen Vorrichtung, die durch die Ausführung der vordefinierten Anzahl von Fertigungsschritten hergestellt wurde, wobei der Abschnitt (700) der realen photonischen und/oder elektronischen Vorrichtung dem Abschnitt (20) der Konstruktion der durch die CAD-Daten (10) repräsentierten photonischen und/oder elektronischen Vorrichtung entspricht;
c) Empfangen von auf den CAD-Daten (10) basierenden Eingangsdaten durch das neuronale Netz (30);
d) Erzeugen, durch das neuronale Netz (30) und auf der Basis der empfangenen Eingangsdaten, einer Simulation (400) eines optischen Bildes von mindestens dem Abschnitt (20) der durch die CAD-Daten (10) repräsentierten photonischen und/oder elektronischen Vorrichtung, wobei das Erzeugen der Simulation (400) des optischen Bildes durch das neuronale Netz (30) auf einem Farbquantisierungsprozess basiert, wobei die Farbinformation in eine Farbkategorie einer Vielzahl von Farbkategorien diskretisiert wird, und wobei ein Ausgang des neuronalen Netzes (30) Daten umfasst oder aus Daten besteht, die sich auf die Farbkategorien beziehen; und
e) Vergleichen des realen optischen Bildes (70) und des simulierten optischen Bildes (400).

9. System zum Simulieren eines optischen Bildes einer photonischen und/oder elektronischen Vorrichtung, insbesondere zur Durchführung des Verfahrens nach einem der Ansprüche 1 bis 7, umfassend:
- eine CAD-Vorrichtung, die dazu ausgebildet ist, CAD-Daten (10) bereitzustellen, die eine Konstruktion von mindestens einem Abschnitt (20) der photonischen und/oder elektronischen Vorrichtung repräsentieren, nach einer vordefinierten Anzahl von Fertigungsschritten eines Herstellungsverfahrens zur Herstellung der photonischen und/oder elektronischen Vorrichtung; und
- eine neuronale Netzvorrichtung mit einem neuronalen Netz (30), das dazu ausgebildet ist, auf den CAD-Daten (10) basierende Eingangsdaten zu empfangen, wobei das neuronale Netz (30) trainiert wird, um eine Simulation (40) von mindestens dem Abschnitt (20) eines optischen Bildes der durch die CAD-Daten (10) repräsentierten photonischen und/oder elektronischen Vorrichtung auf der Basis der empfangenen Eingangsdaten zu erzeugen, wobei das Erzeugen der Simulation (40) des optischen Bildes durch das neuronale Netz (30) auf einem Farbquantisierungsprozess basiert, wobei die Farbinformation in eine Farbkategorie einer Vielzahl von Farbkategorien diskretisiert wird, und wobei ein Ausgang des neuronalen Netzes (30) Daten umfasst oder aus Daten besteht, die sich auf die Farbkategorien beziehen;
- eine Bilderzeugungsvorrichtung, die dazu ausgebildet ist, ein reales optisches Bild (50) mindestens eines Abschnitts (500) einer durch die Ausführung der vordefinierten Anzahl von Fertigungsschritten hergestellten realen photonischen und/oder elektronischen Vorrichtung zu erzeugen, wobei der Abschnitt (500) der realen photonischen und/oder elektronischen Vorrichtung dem Abschnitt (20) der Konstruktion der durch die CAD-Daten (10) repräsentierten photonischen und/oder elektronischen Vorrichtung entspricht; und
- eine Fehlererkennungsvorrichtung, die dazu ausgebildet ist, Fehler (600) der photonischen und/oder elektronischen Vorrichtung unter Verwendung des realen optischen Bildes (50) und des simulierten optischen Bildes (40) zu erkennen.

10. System nach Anspruch 9, wobei die Fehlererkennungsvorrichtung dazu ausgebildet ist, das reale optische Bild (50) mit dem simulierten optischen Bild (40) zu vergleichen, um Fehler der photonischen und/oder elektronischen Vorrichtung zu erkennen.

11. Computerprogrammprodukt mit Anweisungen, die bei Ausführung des Programms durch einen Computer den Computer dazu veranlassen, die Schritte des Verfahrens nach einem der Ansprüche 1 bis 8 auszuführen.

## Revendications

1. Procédé de simulation d'une image optique d'un dispositif photonique et/ou électronique, comprenant les étapes suivantes :
- fournir des données CAO (10) représentant une construction d'au moins une partie (20) du dispositif photonique et/ou électronique après un nombre prédéfini d'étapes de production d'un processus de production pour produire ledit dispositif photonique et/ou électronique ;
- recevoir, par un réseau neuronal (30), de données d'entrée basées sur les données CAO (10), le réseau neuronal (30) étant entraîné pour générer une simulation d'une image optique du dispositif photonique et/ou électronique sur la base des données d'entrée reçues ;
- générer, à l'aide du réseau neuronal (30), une simulation (40) d'une image optique d'au moins la partie (20) du dispositif photonique et/ou électronique représentée par les données CAO (10), la génération de la simulation (40) de l'image optique par le réseau neuronal (30) étant basée sur un processus de quantification de couleurs, dans lequel les informations de couleur sont discrétisées en l'une d'une pluralité de catégories de couleurs, et dans lequel une sortie du réseau neuronal (30) comprend ou consiste en des données relatives aux catégories de couleurs ;
- la capture d'une image optique réelle (50) d'au moins une partie (500) d'un dispositif photonique et/ou électronique réel produit en effectuant le nombre prédéfini d'étapes de production, la partie (500) du dispositif photonique et/ou électronique réel correspondant à la partie (20) de la construction du dispositif photonique et/ou électronique représentée par les données CAO (10) ; et
- l'utilisation de l'image optique réelle (50) et de l'image optique simulée (40) afin de détecter des défauts (600) du dispositif photonique et/ou électronique.

2. Procédé selon la revendication 1, dans lequel les données CAO (10) représentent une structure d'au moins un masque de photolithographie destiné à être utilisé au cours des étapes de production.

3. Procédé selon la revendication 1 ou 2, dans lequel les données CAO (10) sont organisées en un nombre prédéterminé k de couches (11-14).

4. Procédé selon la revendication 3, dans lequel au moins l'une des couches (11-14) représente une structure d'un masque de photolithographie.

5. Procédé selon l'une quelconque des revendications précédentes, dans lequel les données CAO (10) constituent une représentation graphique à base de pixels ou vectorielle d'au moins la partie (20) du dispositif photonique et/ou électronique.

6. Procédé selon l'une quelconque des revendications 3 à 5, dans lequel les données d'entrée sont un masque binaire obtenu par discrétisation d'au moins une partie des données CAO (10).

7. Procédé selon l'une quelconque des revendications précédentes, dans lequel les données CAO (10) contiennent des informations représentant au moins un repère d'alignement, et dans lequel l'image optique réelle (50) est alignée sur l'image optique simulée (40) en utilisant ledit au moins un repère d'alignement.

8. Procédé pour entraîner un réseau neuronal, en particulier pour utilisation dans le procédé selon l'une quelconque des revendications précédentes, comprenant les étapes suivantes :
a) fournir des données CAO (10) représentant la construction d'au moins une partie (20) du dispositif photonique et/ou électronique après un nombre prédéfini d'étapes de production d'un processus de production pour produire ledit dispositif photonique et/ou électronique ;
b) fournir une image optique réelle (70) d'au moins une partie (700) d'un dispositif photonique et/ou électronique réel produit en effectuant le nombre prédéfini d'étapes de production, la partie (700) du dispositif photonique et/ou électronique réel correspondant à la partie (20) de la construction du dispositif photonique et/ou électronique représentée par les données CAO (10) ; et
c) la réception, par le réseau neuronal (30), de données d'entrée basées sur les données CAO (10) ;
d) générer, à l'aide du réseau neuronal (30) et sur la base des données d'entrée reçues, une simulation (400) d'une image optique d'au moins la partie (20) du dispositif photonique et/ou électronique représentée par les données CAO (10), la génération de la simulation (400) de l'image optique par le réseau neuronal (30) étant basée sur un processus de quantification de couleurs, dans lequel les informations de couleur sont discrétisées en l'une d'une pluralité de catégories de couleurs, et dans lequel une sortie du réseau neuronal (30) comprend ou consiste en des données relatives aux catégories de couleurs ; et
e) comparer l'image optique réelle (70) et l'image optique simulée (400).

9. Système destiné à simuler une image optique d'un dispositif photonique et/ou électronique, en particulier pour mettre en œuvre le procédé selon l'une quelconque des revendications 1 à 7, comprenant :
- un dispositif de CAO configuré pour fournir des données CAO (10) représentant une construction d'au moins une partie (20) du dispositif photonique et/ou électronique après un nombre prédéfini d'étapes de production d'un processus de production pour produire ledit dispositif photonique et/ou électronique ; et
- un dispositif à réseau neuronal comprenant un réseau neuronal (30) configuré pour recevoir des données d'entrée basées sur les données CAO (10), dans lequel le réseau neuronal (30) est entraîné pour générer une simulation (40) d'au moins la partie (20) d'une image optique du dispositif photonique et/ou électronique représenté par les données CAO (10) sur la base des données d'entrée reçues, la génération de la simulation (40) de l'image optique par le réseau neuronal (30) étant basée sur un processus de quantification de couleurs, dans lequel les informations de couleur sont discrétisées en l'une d'une pluralité de catégories de couleurs, et dans lequel une sortie du réseau neuronal (30) comprend ou consiste en des données relatives aux catégories de couleurs ;
- un dispositif d'imagerie configuré pour générer une image optique réelle (50) d'au moins une partie (500) d'un dispositif photonique et/ou électronique réel produit en effectuant le nombre prédéfini d'étapes de production, la partie (500) du dispositif photonique et/ou électronique réel correspondant à la partie (20) de la construction du dispositif photonique et/ou électronique représentée par les données CAO (10) ; et
- un dispositif de détection de défauts configuré pour détecter les défauts (600) du dispositif photonique et/ou électronique en utilisant l'image optique réelle (50) et l'image optique simulée (40).

10. Système selon la revendication 9, dans lequel le dispositif de détection de défauts est configuré pour comparer l'image optique réelle (50) à l'image optique simulée (40) afin de détecter des défauts du dispositif photonique et/ou électronique.

11. Produit logiciel comprenant des instructions qui, lorsque le programme est exécuté par un ordinateur, amènent l'ordinateur à mettre en œuvre les étapes du procédé selon l'une quelconque des revendications 1 à 8.
